# EUROPÄISCHE PATENTSCHRIFT

(11) **EP 1 124 137 B1**
(45) Veröffentlichungstag und Bekanntmachung des Hinweises auf die Patenterteilung: **06.08.2008**
(21) Anmeldenummer: 01101311.7
(22) Anmeldetag: 20.01.2001
(51) Int. Cl.: G01R 33/28, G01R 33/31, G01R 33/30

(54) **Gekühlter NMR-Probenkopf mit Vorrichtung zur Zentrierung der Messprobe**
Cooled NMR probe head with means for centering the probe
Tête refroidie de support d'échantillon pour RMN avec dispositif de centrage d'échantillon

(30) Priorität: 12.02.2000 DE 10006324
(43) Veröffentlichungstag der Anmeldung: 16.08.2001
(73) Patentinhaber: Bruker BioSpin AG, 8117 Fällanden (CH)
(72) Erfinder: Marek, Daniel, 5103 Möriken (CH)
(74) Vertreter: Kohler Schmid Möbus

(56) Entgegenhaltungen:
- US-A- 3 764 892
- US-A- 4 052 661
- US-A- 4 088 944
- US-A- 5 469 061
- BODEN N ET AL: "SAMPLE CELL FOR HIGH-PRECISION TEMPERATURE-DEPENDENCE NMR EXPERIMENTS" JOURNAL OF MAGNETIC RESONANCE, ACADEMIC PRESS, ORLANDO, FL, US, Bd. 98, Nr. 1, 1. Juni 1992 (1992-06-01), Seiten 92-108, XP000275048 ISSN: 1090-7807
- BARJAT H ET AL: "ADAPTATION OF COMMERCIAL 500 MHZ PROBES FOR LCNMR" JOURNAL OF MAGNETIC RESONANCE. SERIES A, ACADEMIC PRESS, ORLANDO, FL, US, Bd. 119, Nr. 1, 1. März 1996 (1996-03-01), Seiten 115-119, XP000559746 ISSN: 1064-1858

## Beschreibung

Die Erfindung betrifft einen NMR(= Kernspinresonanz)-Probenkopf mit einem auf kryogene Temperaturen abkühlbaren HF(= Hochfrequenz)-Empfangsspulensystem und einem längs einer z-Achse verlaufenden um die Achse zylindersymmetrischen Raumtemperaturrohr, in das ein zylindrisches Probenröhrchen eingeführt ist, welches mittels NMR-Messung zu untersuchende Probensubstanz enthält, wobei das HF-Empfangsspulensystem in einem evakuierten Raum außerhalb des Raumtemperaturrohrs angeordnet ist.

Ein solcher gekühlter NMR-Probenkopf ist beispielsweise bekannt aus der US-A 5,247,256 oder der US-A 5,689,187.

Der Probenkopf wird in einem Magneten zum Erzeugen eines hochgradig homogenen, statischen B₀-Feldes eingebaut und enthält um eine z-Achse angeordnete HF-Empfangsspulen, welche mittels geeigneter Wärmetauscher und Wärmeleitungselemente im Betrieb bis auf Temperaturen von ca. 10 - 25 K abgekühlt werden, um bei der Messung das Signal-zu-Rausch-Verhältnis des empfangenen NMR-Signals zu verbessern. Die HF-Empfangsspulen befinden sich zum Zwecke der Wärmeisolation in einem evakuierten Raum, der im wesentlichen durch ein in der Regel metallisches Gehäuse des Probenkopfes gebildet wird, welches von einem um die z-Achse zylindrisch angeordneten Raumtemperaturrohr zur Aufnahme eines Probenröhrchens durchbrochen ist. Damit die HF-Signale von der Probe zu den HF-Empfangsspulen gelangen können, ist im axialen Bereich der Spulen das ansonsten normalerweise metallische Raumtemperaturrohr durch ein HF-durchlässiges Innenrohr, meist ein Glasrohr ersetzt, welches vakuumdicht an die metallischen Teile des Raumtemperaturrohres anschließt.

Zur Temperierung der Probensubstanz wird das Probenrohr nach dem Einführen in das Raumtemperaturrohr von unten her mittels eines warmen Luftstroms durch das Raumtemperaturrohr im wesentlichen auf einer gewünschten Temperatur (meist ca. 300 K) gehalten. Dabei tritt jedoch das Problem auf, daß die Meßprobe die ganz erheblich kühlere Umgebung des auf 10 - 25 K gekühlten NMR-Resonators "sieht" und dorthin ihre Wärme in radialer Richtung abstrahlt. Diese abgehende Wärme muß kontinuierlich vom aufsteigenden warmen Temperier-Luftstrom wieder zugeführt werden, damit die Meßprobe im wesentlichen auf der gewünschten Temperatur bleibt. Dieser Vorgang hat nun zur Folge, daß in der Meßprobe ein axialer und radialer Temperaturgradient entsteht, der die NMR-Messung stark stört.

Aufgabe der vorliegenden Erfindung ist es daher, einen gekühlten NMR-Probenkopf mit den eingangs genannten Merkmalen vorzustellen, bei dem mit möglichst einfachen technischen Mitteln die auftretenden Temperaturgradienten im Betrieb wesentlich verringert sind, ohne daß die NMR-Messung dabei beeinträchtigt wird.

Erfindungsgemäß wird diese Aufgabe auf ebenso überraschend einfache wie wirkungsvolle Art und Weise dadurch gelöst, daß zur Reduzierung eines Temperaturgradienten in einer Ebene senkrecht zur z-Achse innerhalb der Probensubstanz im Probenröhrchen eine Zentriervorrichtung um die Achse des Raumtemperaturrohres vorgesehen ist, die eine Zentrierung des Probenröhrchens bezüglich des Raumtemperaturrohres bewirkt, wenn sich das Probenröhrchen in Messposition befindet, wobei die Zentriervorrichtung mehrere zwischen dem Raumtemperaturrohr und dem Probenröhrchen azimuthal beabstandete, symmetrisch um die z-Achse des Raumtemperaturrohres herum angeordnete und an der dem Probenröhrchen zugewandten Seite des Raumtemperarturrohr angebrachte Abstandshalter mit zur z-Achse ausschließlich radialer Zentrierwirkung umfasst, wobei im Falle des Zusammenfallens der Zylinderachse des Probenröhrchens mit der z-Achse zwischen den Abstandshaltern und dem Probenröhrchen jeweils ein freier Abstand b verbleibt und wobei zwischen dem Raumtemperaturrohr und dem Probenröhrchen ein radialer Abstand > b vorhanden ist, und daß die Abstandhalter aus in Richtung der z-Achse ausgedehnten Streifen aus federndem Material bestehen, die an ihrem dem Probenröhrchen in dessen Meßposition abgewandten Ende starr mit dem Raumtemperaturrohr verbunden sind, und die an ihrem dem Probenröhrchen in dessen Meßposition zugewandten Ende eine zum Probenröhrchen hin ausgebauchte Sicke aufweisen, deren freier Schenkel an dem Raumtemperaturrohr anliegt.

Die erfindungsgemäße Zentriervorrichtung ist besonders einfach und preiswert herstellbar und kann nachträglich ohne weiteres in bereits vorhandene NMR-Probenköpfe eingebaut werden.

Aus der US-A 3,525,928 ist ein V-förmiger Probenröhrchenhalter in einem NMR-Probenkopf bekannt, gegen den das untere Ende des Probenröhrchens aufliegt. Zwar wird mit diesem Halter auch eine gewisse Zentrierung des Probenröhrchens in seiner Meßposition um die Achse des Raumtemperaturrohres erreicht, jedoch wirkt diese Halterung nicht ausschließlich radial zur z-Achse, wie die erfindungsgemäßen Abstandhalter, sondern erzeugt auch eine axiale starre Halterung des Probenröhrchens, welches bei der erfindungsgemäßen Anordnung in seiner axialen Position durch den Abstandhalter nicht beeinflußt wird. Außerdem ist bei der bekannten Anordnung nach der US-A 3,525,928 eine Abkühlung der HF-Empfangsantenne auf kryogene Temperaturen nicht vorgesehen, so daß die oben geschilderten technischen Probleme, zu deren Lösung die vorliegende Erfindung beiträgt, nicht auftreten

Die US-A 4,052,661 zeigt einen NMR-Probenkopf für einen Polschuhmagneten, in dem Störspannungen in der HF-Empfangsspule kompensiert werden sollen. Die HF-Empfangsspule wird bei Zimmertemperatur betrieben. In einer zylindrischen Bohrung des NMR-Probenkopfs soll ein zylindrischer Probenhalter angeordnet werden, der um die Achse der Bohrung rotiert. Diese Bohrung weist zwei Lager mit jeweils drei nach innen ragenden Vorsprüngen zur Halterung des Probenhalters während der Rotation auf.

Zu den erfindungsgemäßen NMR-Probenköpfen zählen neben denjenigen mit auswechselbaren Probenröhrchen auch sogenannte Durchflußköpfe, bei denen das Probenröhrchen fix eingebaut bleibt und die zu untersuchende Flüssigkeit durch eine dünne Leitung auf der einen Seite (unten) eingelassen wird und auf der anderen Seite (oben) hinausgeführt wird. Solche Probenköpfe können sowohl im kontinuierlichen Durchfluß wie auch im Flow- und Stop-Betrieb (für eine verlängerte Meßperiode) verwendet werden. Diese Probenköpfe werden einerseits für eine schnelle Sample-Einführung gebraucht, andererseits auch als eine sehr aussagekräftige Analysestufe, die einer Flüssig-Chromatographie Trennzelle nachgeschaltet wird. Im ersteren Fall spricht man von Durchflußprobenköpfen, im zweiten von LC-NMR Kopplung. Solche Probenköpfe werden auch als LC-Köpfe bezeichnet (Liquid Chromatography, im speziellen auch HPLC (High Pressure Liquid Chromatography). Derartige Probenköpfe können in besonderem Maße von der Kryo-Technologie und mithin von den erfindungsgemäßen Modifikationen profitieren.

Die Quertemperaturgradienten radial zur z-Achse, die beim Betrieb eines gekühlten NMR-Probenkopfes auftreten können und wesentlich verantwortlich für die Instabilitäten im Spektrum wie auch im Lock-System sind, ergeben sich aus der Aufintegration der lokalen axialen Temperaturgradienten vom Boden der Probe aus bis zum betrachteten Punkt entlang z. Die lokalen axialen Temperaturgradienten ergeben sich als Produkt aus dem Wärmeverlust pro Flächeneinheit und dem lokalen Reziprokwert des Massenstromes von Temperiergas. Diese Massenstromverteilung ist abhängig von der Asymmetrie und der Winkelabweichung der Achse des Probenröhrchens von der z-Achse des Raumtemperaturrohres. Da diese Asymmetrie als Faktor in das gesamte Produkt eingeht, treten auch schon bei kleinen Achsversätzen oder Schrägstellungen der Meßprobe innerhalb des Raumtemperaturrohres große Einflüsse auf den Temperierungsfluß auf. Daher kann mit der vorgeschlagenen Zentriervorrichtung ein erheblicher Effekt im Sinne einer Verringerung der Temperaturgradienten in der xy-Ebene und einer Verbesserung der Qualität der NMR-Signale im gekühlten Probenkopf bewirkt werden.

Die Abstandhalter können im Bereich des Bodens des Probenröhrchens in dessen Meßposition und/oder im Bereich der Einfüllöffnung des Raumtemperaturrohres an der dem Probenröhrchen zugewandten Seite des Raumtemperaturrohres angebracht sein.

Alternativ können sich die Abstandhalter aber auch über die gesamte axiale Länge des HF-Empfangsspulensystems erstrecken um so eine möglichst genaue Zentrierung des Probenröhrchens im Raumtemperaturrohr zu bewirken.

Bei vorteilhaften Ausführungsformen des erfindungsgemäßen NMR-Probenkopfes sind mehrere, vorzugsweise zwischen 3 und 8, insbesondere 6 Abstandhalter symmetrisch verteilt um die z-Achse des Raumtemperaturrohres herum angeordnet. Damit ließen sich bislang die besten Ergebnisse erzielen.

Um die NMR-Messungen nicht zu stören, sollten die Abstandhalter aus einem für die HF-Strahlung transparenten, wenn möglich auch aus einem magnetisch kompensierten Material aufgebaut sein.

Bei einer bevorzugten Weiterbildung bestehen die Abstandhalter aus Blechstreifen mit einer Dicke von etwa 100µm und einer Breite quer zur z-Achse von etwa 0,5mm bis 2mm, vorzugsweise etwa 1mm.

Eine besonders bevorzugte Ausführungsform des erfindungsgemäßen NMR-Probenkopfes sieht vor, daß zwischen dem HF-Empfangsspulensystem und dem Raumtemperaturrohr das Raumtemperaturrohr in radialer Richtung umgebende, in z-Richtung ausgedehnte Strahlungsschilde angeordnet sind, welche aus einem oder mehreren in z-Richtung ausgerichteten Materialien aufgebaut sind, die für HF-Felder nahezu vollständig transparent sind, zumindest aber eine Absorption < 5%, vorzugsweise <1% für HF-Felder aufweisen.

In der Kryotechnik ist es zwar an sich seit langem bekannt, bei Wärmestrahlungsverlusten Strahlungsschilde einzusetzen, jedoch verbietet sich dieses Vorgehen zunächst im Falle eines gekühlten NMR-Probenkopfes, weil durch die in der Regel metallischen, Wärmestrahlung reflektierenden Strahlungsschilde eine Ausbreitung der HF-Felder von der Meßprobe zu den HF-Empfangsspulen ebenfalls entweder ganz abgeblockt oder zumindest stark behindert wird, so daß die ankommenden NMR-Signale zumindest extrem stark gedämpft, verzerrt oder überhaupt nicht mehr verwertbar wären.

Durch die erfindungsgemäße Lösung werden jedoch für die im Vakuum zwischen den HF-Spulen und dem Raumtemperaturrohr vorgesehenen Strahlungsschilde nur Materialien verwendet, welche einerseits in z-Richtung eine Ausrichtung besitzen. Die axiale Ausrichtung des Materials der Strahlungsschilde verhindert, daß deren endliche Suszeptibilität die Auflösung der NMR-Signale verschlechtert. Andererseits sollen die Materialien von ihren physikalischen Eigenschaften her im Bereich von Hochfrequenz-Strahlung möglichst transparent sein. Meistens muß die letztgenannte Materialeigenschaft aber damit erkauft werden, daß keine allzu hohe Rückreflektion der Verlustwärme zur Meßprobe hin erwartet werden kann.

Vorteilhaft ist es, wenn in radialer Richtung wenigstens ein minimaler Abstand zwischen den Strahlungsschilden voneinander vorhanden ist und sich die Strahlungsschilde nicht oder zumindest nur punktuell bzw. linienförmig berühren, damit keine direkte Wärmeleitung zwischen den einzelnen Strahlungsschilden in radialer Richtung entsteht, die zu einem thermischen "Kurzschluß" führen würde. Allerdings stellt auch ein gelegentliches Berühren der Strahlungsschilde kein ernstliches Problem dar, insbesondere wenn ein Material gewählt wird, welches ohnehin eine sehr niedrige Wärmeleitung aufweist. So lange die einzelnen Berührungspunkte bzw. -linien genügend weit auseinanderliegen, ist die gesamte Wärmeleitung zwischen den radial angeordneten Strahlungsschilden für die erfindungsgemäßen Zwecke im wesentlichen vernachlässigbar.

Besonders bevorzugt ist eine Weiterbildung, bei der die Strahlungsschilde aus Material aufgebaut sind, welches Strahlung in einem Wellenlängenbereich 10µm ≤ λ ≤ 100µm reflektiert oder zumindest absorbiert, und welches für Strahlung in einem Wellenlängenbereich λ > 100mm transparent ist. Der erstgenannte Wellenlängenbereich entspricht Wärmestrahlung auf einer Temperatur zwischen ca. 20 K bis 300 K, was der Temperaturdifferenz zwischen der Meßprobe und den gekühlten NMR-Spulen gleichkommt, während der zweite Wellenlängenbereich einer Strahlung mit einer Frequenz oberhalb von 3 GHz entspricht, während der für die NMR-Messungen wichtige HF-Bereich zwischen einigen MHz unter etwa 1 GHz liegt.

Ein optimales Material, welches praktisch keine Absorptionsverluste im betrachteten HF-Bereich aufweist, andererseits aber für den obengenannten Wärmestrahlungsbereich nicht transparent ist, ist beispielsweise Glas oder Quarz.

Die Strahlungsschilde des erfindungsgemäßen NMR-Probenkopfes könnten theoretisch als koaxial um das Raumtemperaturrohr herumlaufende Rohre ausgeführt sein. Jedoch dürfte das Rohrmaterial in der Regel eine zu große Dicke aufweisen. Möglich ist auch der Aufbau der Strahlungsschilde aus einer unidirektionalen Folie, deren Herstellung und Verarbeitung allerdings relativ schwierig ist. Die Ausrichtung der Folie längs der z-Achse kann beispielsweise durch Anwendung mechanischer Zugspannung hergestellt werden. Bevorzugt ist demgegenüber eine Ausführungsform, bei der die Strahlungsschilde aus einem unidirektionalen Gewebe aufgebaut sind. Derartige unidirektionale Gewebe aus entsprechend geeigneten Materialien sind ohne weiteres im Handel erhältlich.

Bevorzugt bestehen diese Gewebe aus Fasermatten, insbesondere Glasfasermatten, die aus Fasern mit Durchmessern von weniger als 10µm aufgebaut sind und insgesamt eine Dicke von etwa 30 µm aufweisen. Anstelle einer radialen Abfolge von zylindrischen Einzel-Strahlungsschilden kann bei der Verwendung von derartigen Glasfasermatten auch an ein schneckenförmiges Umwickeln des Raumtemperaturrohres auf seiner Vakuumseite in mehreren Lagen gedacht werden.

Bei einer weiteren besonders bevorzugten Ausführungsform sind die Strahlungsschilde aus in z-Richtung ausgerichteten, radial um die Achse des Raumtemperaturrohres angeordneten Stäben oder Fasern, vorzugsweise Glasfasern und/oder Quarzfasern aufgebaut. Derartige Fasern sind mit Durchmessern zwischen 10 und 50 um im Handel erhältlich. Es gibt allerdings auch Glasfilamente mit Durchmessern von weniger als 5µm, die allerdings schwierig zu verarbeiten sein dürften.

Bei einer vorteilhaften Weiterbildung sind die Strahlungsschilde aus Faserbündeln aufgebaut, die insgesamt dann wieder eine etwas höhere mechanische Stabilität als die Einzelfilamente aufweisen und daher bei ihrer Verarbeitung ähnlich wie Stäbe einfacher zu handhaben sind.

Die Stäbe oder Fasern können bei Ausführungsformen lose im Raum angeordnet und nur an ihren Enden befestigt sein.

Alternativ können die Stäbe oder Fasern aber auch an einem zum Raumtemperaturrohr koaxial angeordneten Trägerrohr, vorzugsweise an der dem HF-Empfangsspulensystem zugewandten Seite des Raumtemperaturrohres selbst befestigt sein.

Bei einer bevorzugten Weiterbildung sind die Stäbe oder Fasern am Trägerrohr bzw. am Raumtemperaturrohr mit einem für HF-Strahlung transparenten Klebstoff befestigt, so daß keine Dämpfung der HF-Strahlung von der Meßprobe zu der HF-Empfangsspule aufgrund der Verklebung erfolgt.

Vorteilhaft ist auch eine Weiterbildung, bei der die Stäbe oder Fasern in Umfangsrichtung um die Achse des Raumtemperaturrohres herum dicht gepackt angeordnet sind, so daß in radialer Richtung kein "optischer Durchblick" besteht. Auf diese Weise bilden die Stäbe oder Fasern jeweils einen in Umfangsrichtung zusammenhängenden Strahlungsschild.

Besonders bevorzugt ist weiterhin eine Ausführungsform des erfindungsgemä-ßen NMR-Probenkopfes, bei der zwischen dem HF-Empfangsspulensystem und dem Probenröhrchen eine das Probenröhrchen in radialer Richtung umgebende, in z-Richtung ausgedehnte Temperiereinrichtung angeordnet ist, welche vorzugsweise aus Material hoher thermischer Leitfähigkeit aufgebaut ist und für HF-Felder nahezu vollständig transparent ist, zumindest aber eine Absorption < 5%, vorzugsweise < 1% für HF-Felder aufweist.

Damit wird eine Wärmeableitung aus der Meßprobe und somit eine ungleichmäßige Abkühlung verhindert, ohne daß die empfangenen NMR-Signale wesentlich beeinträchtigt werden. Der Vorteil einer derartigen Temperiereinrichtung gegenüber einem geheizten Luftstrom für das Probenröhrchen liegt vor allem darin, daß die Heizleistung gleichmäßig über die gesamte axiale Länge des Probenröhrchens erfolgen kann. Der mittlere Bereich wird damit ebenso gut temperiert wie die Randbereiche. Auf diese Weise können axiale Temperaturgradienten wirksam verhindert werden.

Im Gegensatz dazu tritt ein herkömmlicher geheizter Luftstrom ohne die erfindungsgemäße Heizeinrichtung normalerweise am unteren Ende des Probenröhrchens in das Raumtemperaturrohr ein, gibt von da an seine Wärme an das Probenröhrchen ab und kühlt sich dabei beim Aufsteigen in axialer Richtung immer weiter ab. Die Temperatur des geheizten Luftstroms im oberen Bereich des Probenröhrchens wird deshalb immer kleiner sein als die im unteren Bereich, wodurch sich zwangsläufig die Temperierleistung im oberen Bereich des Probenröhrchens verringert. Als Folge daraus entsteht immer ein axialer Temperaturgradient, der sich durch Vergrößerung der Luftmenge pro Zeiteinheit zwar etwas verringern läßt, jedoch prinzipiell nicht verhindert werden kann. Außerdem sind den entsprechenden Gegenmaßnahmen enge Grenzen gesetzt, da bei einer zu großen Luftmenge pro Zeiteinheit eine vibrationsfreie Lage oder saubere Rotation des Probenröhrchens nicht mehr gewährleistet werden kann.

Eine mögliche Weiterbildung dieser Ausführungsform besteht darin, daß die Temperiereinrichtung eine das Probenröhrchen im axialen Bereich des HF-Empfangsspulensystems radial umgebende Schicht mit einer radialen Dicke < 1 mm, vorzugsweise < 50µm umfaßt, die aus Material aufgebaut ist, welches Strahlung in einem Wellenlängenbereich 100nm ≤ λ ≤ 100µm zumindest teilweise absorbiert, und welches für Strahlung in einem Wellenlängenbereich λ > 100mm transparent ist.

Vorzugsweise ist zur gleichmäßigen Erwärmung der Schicht eine Heizeinrichtung im erfindungsgemäßen NMR-Probenkopf vorgesehen.

Eine bevorzugte Weiterbildung zeichnet sich dadurch aus, daß die Heizeinrichtung eine Vorrichtung zum Bestrahlen der Schicht mit Strahlung aus dem Wellenlängenbereich 100nm ≤ λ ≤ 100µm, insbesondere mit Wärmestrahlung umfaßt, die vorzugsweise auf der dem HF-Empfangsspulensystem zugewandten Seite des Raumtemperaturrohres angeordnet ist.

Viele mögliche Materialien, aus denen das Raumtemperaturrohr ausgebildet werden kann, weisen bereits eine Absorption im gewünschten Wellenlängenbereich auf, so daß bei einer Aufheizung durch Bestrahlung auf eine besondere strahlungsabsorbierende Schicht verzichtet werden kann.

Die strahlungsabsorbierende Heizschicht kann das Raumtemperaturrohr flächig umgeben. Alternativ kann die Schicht aber auch um das Raumtemperaturrohr herum in axial verlaufenden, in Umfangsrichtung voneinander beabstandeten Streifen angeordnet sein.

Besonders bevorzugt ist eine Weiterbildung, bei der die Schicht elektrisch leitfähig und durch Anlegen einer elektrischen Spannung beheizbar ist.

Alternativ oder zusätzlich ist bei einer weiteren Ausführungsform vorgesehen, daß die Temperiereinrichtung eine oder mehrere Heizschlaufen aus dünnem, insbesondere schichtförmigem, elektrisch gut leitfähigem Material umfaßt, die jeweils einen Hin- und einen Rückleiter aufweisen, wobei die Hin- und Rückleiter der Heizschlaufen jeweils einenends elektrisch miteinander verbunden sind und anderenends mit Heizstrom aus einer Stromquelle beschickt werden können.

Besonders bevorzugt sind die Hin- und Rückleiter der Heizschlaufen bifilar mit möglichst geringem Abstand voneinander angeordnet, um die Ausbildung eines störenden Magnetfelds bei Stromdurchfluß möglichst gering zu halten.

Dazu ist es vorteilhaft, wenn die Hin- und Rückleiter der Heizschlaufen aus zwei übereinander angeordneten länglichen Streifen bestehen, welche durch eine Isolierschicht bzw. einen Isolierstreifen elektrisch voneinander isoliert sind.

Besonders bevorzugt ist eine Weiterbildung, bei der die Hin- und Rückleiter der Heizschlaufen aus Materialien von unterschiedlicher magnetischer Suszeptibilität aufgebaut sind, die so ausgewählt sind, daß die gesamte Heizschlaufe jeweils nach außen magnetisch kompensiert ist.

Geometrisch kann die Temperiereinrichtung so aufgebaut sein, daß eine oder mehrere Heizschlaufen wendelförmig um das Raumtemperaturrohr herum angeordnet sind.

Alternativ können aber auch mehrere, vorzugsweise mindestens 8 Heizschlaufen mit Abstand voneinander in Umfangsrichtung um die z-Achse des Raumtemperaturrohres herum angeordnet sind und sich parallel zur z-Richtung erstrecken.

Vorteilhafterweise sind die Heizschlaufen räumlich so orientiert, daß ihre Kopplung zum HF-Empfangsspulensystem minimal ist.

Besonders bevorzugt ist eine Ausbildung der Heizschlaufen aus einem möglichst gut elektrisch leitenden Material (z.B. Cu), wobei die Leiter rechteckförmige, möglichst quadratische oder kreisrunde Querschnitte haben (typischerweise in der Größenordnung von 10 µm x 10µm oder kleiner ). Durch die sich daraus ergebende sehr kleine Gesamt-Flächenbedeckung bleibt das Raumtemperaturrohr für die HF-Felder sehr gut durchlässig, auch die HF-Verluste werden durch sowohl die kleinen Oberflächen der Heizleiter wie auch durch die gute elektrische (und somit HF)Leitfähigkeit sehr tief gehalten.

Bei einer bevorzugten Weiterbildung der oben geschilderten Ausführungsformen kann zwischen der Stromquelle und den Heizschlaufen ein Tief-Paß-Filter vorgesehen sein, um eine Signalverschleppung sowie die Restdämpfung möglichst niedrig zu halten.

Bevorzugt ist auch eine Weiterbildung, bei der zwischen der Stromquelle und den Heizschlaufen ein Parallel-Schwingkreis vorgesehen ist, dessen Resonanzfrequenz bei der empfindlichsten für die NMR-Messung relevanten HF-Frequenz liegt. Ein solcher Sperrkreis verhindert ebenfalls die Aussendung von Störsignalen an das HF-Empfangsspulensystem und minimiert eine unerwünschte Auskopplung der HF-Signale durch die Heizschlaufen.

Um weitere Störungen des statischen Magnetfeldes möglichst gering zu halten, ist es bei einer Weiterbildung schließlich vorteilhaft, wenn die Stromquelle die Heizschlaufe mit Wechselstrom beschickt. Dabei wird die Kreisfrequenz so gewählt, daß die entstehenden Seitenbanden ausschließlich außerhalb des beobachteten NMR-Spektralfensters liegen.

Die Erfindung ist in der Zeichnung dargestellt und wird anhand von Ausführungsbeispielen näher erläutert. Es zeigen:
- Fig. 1a: einen schematischen Vertikalschnitt durch eine erfindungsgemäße Anordnung mit Zentriervorrichtung;
- Fig. 1b: einen Horizontalschnitt durch eine Anordnung nach Fig.1a;
- Fig. 1c: eine vergrößerte Detaildarstellung der Anordnung nach Fig. 1a mit Probenröhrchen in Meßposition;
- Fig. 2: einen schematischen Vertikalschnitt durch einen gekühlten NMR-Probenkopf nach dem Stand der Technik mit zugehörigem Temperaturverlauf in Richtung der z-Achse;
- Fig. 3a: einen schematischen Horizontalschnitt durch eine Anordnung mit asymmetrisch in das Raumtemperaturrohr eingeführtem Probenröhrchen;
- Fig. 3b: die zur Anordnung nach Fig. 3a zugehörige Temperaturverteilung in z-Richtung;
- Fig. 4a: einen schematischen Vertikalschnitt durch ein Raumtemperaturrohr mit asymmetrisch eingeführtem Probenröhrchen und angedeuteten Konvektionsströmungen innerhalb der Meßprobe;
- Fig. 4b: die zugehörigen Temperaturverläufe in Richtung der z-Achse auf der linken und der rechten Seite der Anordnung von Fig. 4a;
- Fig. 5: ein Schema des Temperaturverlaufs des Temperiergases in Richtung der z-Achse bei asymmetrisch in das Raumtemperaturrohr eingeführtem Probenröhrchen und einer gut wärmeleitenden Innenseite des Raumtemperaturrohres im Bereich der HF-Empfangsspulen;
- Fig. 6: einen schematischen Vertikalschnitt durch eine erfindungsgemäße Anordnung mit Temperiereinrichtung und den zugehörigen Temperaturverlauf längs der z-Achse.
- Fig.7a: einen schematischen Vertikalschnitt durch einen erfindungsgemäßen NMR-Probenkopf mit Wärmeschilden zwischen Raumtemperaturrohr und HF-Empfangsspulensystem ; und
- Fig.7b: einen schematischen Horizontalschnitt durch eine Anordnung nach Fig. 7a im axialen Bereich des HF-Empfangsspulensystems;

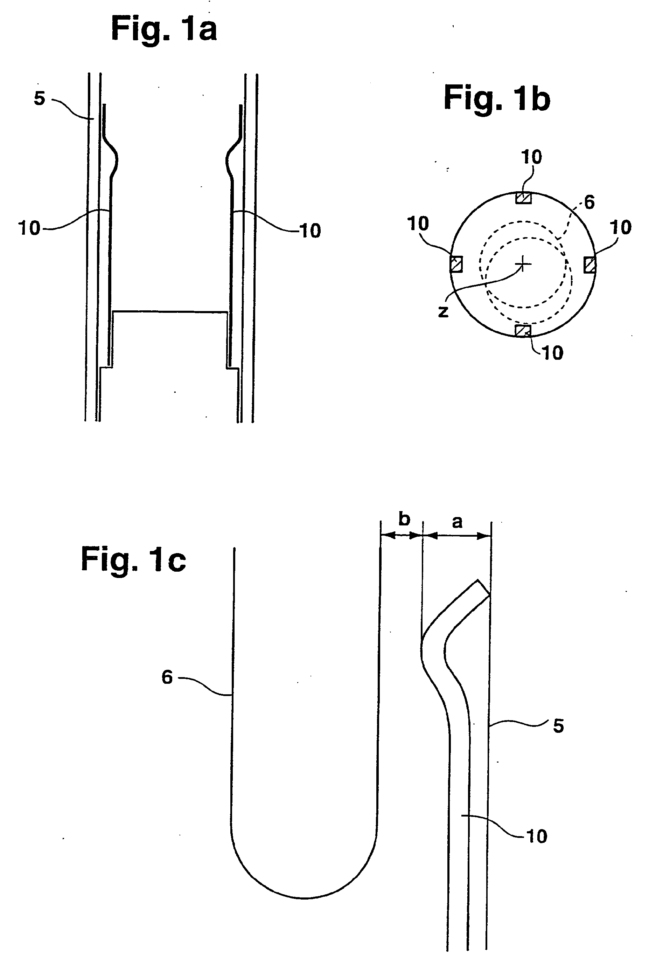

Die Figuren 1a bis 1c zeigen eine bevorzugte Ausführungsform des erfindungsgemäßen NMR-Probenkopfes mit einer Zentriervorrichtung, die im gezeigten Ausführungsbeispiel vier symmetrisch um die z-Achse verteilte Abstandhalter 10 umfaßt. Durch eine damit bewirkte saubere Zentrierung des Probenröhrchens 6 innerhalb des Raumtemperaturrohres 4 können Konvektionsströme und damit die Bildung von Temperaturgradienten innerhalb der Probensubstanz 7 vermieden werden.

Bei derzeit vorhandenen NMR-Probenköpfen liegt der lichte Innendurchmesser des Raumtemperaturrohres 4 im Bereich des Innenrohres 5 bei ca. 5,6 mm, während üblicherweise eingesetzte Probenröhrchen 6 einen Außendurchmesser von 5,0 mm aufweisen. Damit ergibt sich von der Außenwand des Probenröhrchens 6 bis zur Innenwand des Innenrohres 5 ein mittlerer Abstand a + b = 0,3 mm. Dieser ist in Fig. 1c hinsichtlich der Strecke a vom erfindungsgemäßen Abstandhalter 10 definiert überbrückt. Der restliche Abstand b verbleibt zum problemlosen Einführen und möglichst berührungsfreien Rotieren des Probenröhrchens 6 im Raumtemperaturrohr 4. Dabei sollte a in der Größenordnung von 0,2 mm, b bei etwa 0,1 mm liegen. Mit diesen Werten können bereits erhebliche Verbesserungen hinsichtlich der radialen Temperaturgradienten erhalten werden.

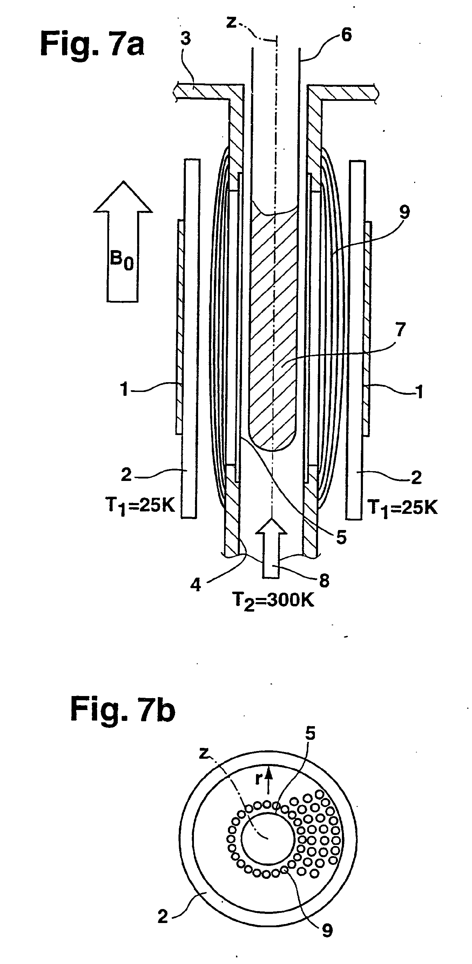

Nähere Einzelheiten des Aufbaus eines erfindungsgemäßen NMR-Probenkopfes können unter anderem der unten beschriebenen Fig. 7a entnommen werden.

Im folgenden soll die Wirkungsweise der erfindungsgemäßen Anordnung erläutert werden:

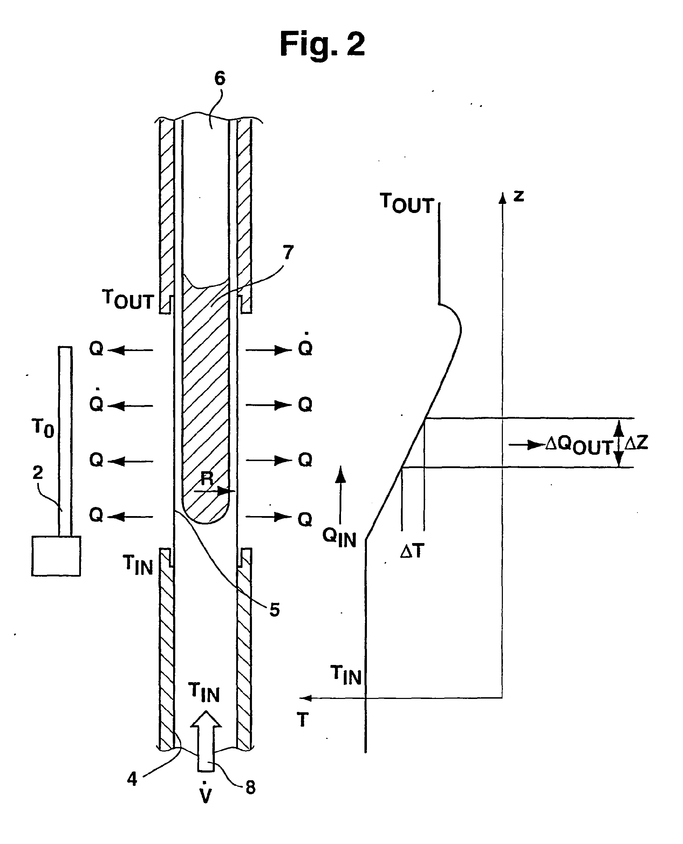

In Fig. 2 ist schematisch ein Ausschnitt aus einem NMR-Probenkopf nach dem Stand der Technik gezeigt, bei den von einem Probenröhrchen 6 radial in Richtung auf das HF-Empfangsspulensystem 1 durch Strahlung Wärmeströme Q abgehen, da das Empfangsspulensystem 1 auf einer kryogenen Temperatur von ungefähr 25 K gehalten wird, während das Probenröhrchen 6 mit Hilfe des von unten her zugeführten temperierten Luftstroms 8 ungefähr auf Zimmertemperatur gehalten werden soll. Durch die Wärmeabstrahlung aus dem Probenröhrchen 6 ergibt sich unter Berücksichtigung der mit dem Temperierstrom 8 zugeführten Wärme ein Temperaturverlauf in axialer Richtung innerhalb des Probenröhrchens 6, wie er auf der rechten Seite von Fig. 2 schematisch gezeigt ist.

Die relativ hohen Temperaturgradienten innerhalb der Probensubstanz 7 führen regelmäßig zu einer unerwünschten Verschlechterung der aufgenommenen NMR-Spektren. Es ergeben sich Linienverbreiterungen aufgrund der Temperaturabhängigkeit der chemischen Verschiebung, was dazu führen kann, daß zwei Substanzen nicht gleichzeitig geshimt werden können. Dieser Effekt ist insbesondere bei Wasser ausgeprägt.

Daneben können, wenn der Temperaturgradient einen kritischen Wert überschritten hat, Konvektionseffekte auftreten. Die sich dabei ergebenden Fluktuationen können die Stabilität beim Shimen und bei den NMR-Experimenten erheblich stören.

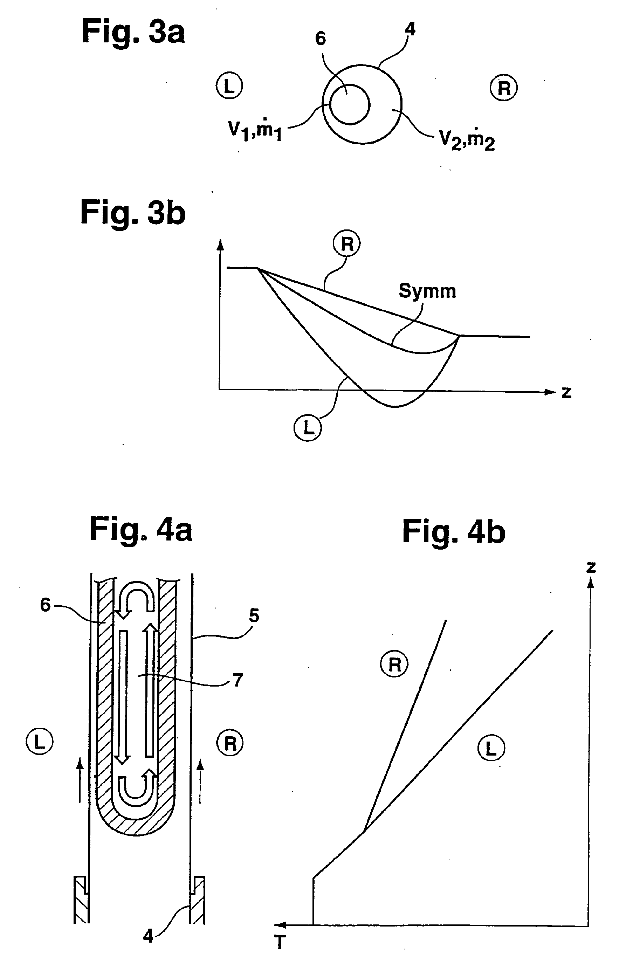

Neben den Temperaturgradienten in z-Richtung können auch transversale Gradienten auftreten, wenn das Probenröhrchen 6 nicht exakt in der Mitte des Raumtemperaturrohres 4 plaziert ist, wie in Fig. 3a in einem Horizontalschnitt schematisch dargestellt.

Durch die unterschiedlichen Massenflüsse, die sich aus den unterschiedlichen Strömungswiderständen auf der linken (L) und der rechten (R) Seite ergeben, treten verschiedene Längsgradienten auf beiden Seiten auf. Dies führt zu einem transversalen Temperaturgradienten, der nach oben hin immer ausgeprägter wird, wie in Fig. 3b dargestellt. Der mittlere der drei gezeigten Temperaturverläufe stellt den symmetrischen Fall dar.

Dieser Gradient begünstigt die Ausbildung einer Konvektion innerhalb der in der Regel flüssigen Probensubstanz 7 zusätzlich. Diese Situation ist in Fig. 4a schematisch dargestellt. Die zugehörigen Temperaturverläufe in z-Richtung sind in Fig. 4b gezeigt. Der Temperaturverlauf auf der rechten Seite (= R) kann dabei ganz erheblich von dem Temperaturverlauf auf der linken Seite (= L) differieren.

Um diesem Effekt entgegenzuwirken, wird der Mittelteil 5 des Raumtemperaturrohres 4 aus gut wärmeleitendem Material ausgeführt. Damit können die transversalen Temperaturgradienten (x-y-Richtung) stark vermindert werden. Es kommen allerdings nur Materialien in Frage, deren Absorption für HF-Strahlung vernachlässigbar gering ist und die gleichzeitig die geforderte hohe Wärmeleitfähigkeit haben. Konkret bietet sich hier Saphir als Material an.

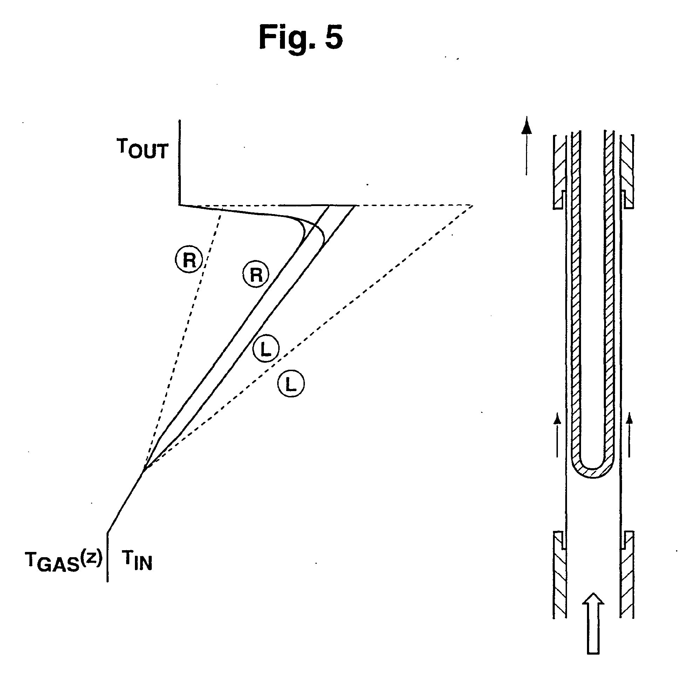

In Fig. 5 ist die Situation ohne gute Wärmeleitung (gestrichelt) und mit guter Wärmeleitung (durchgezogen) des Raumtemperaturrohres 4, insbesondere des Innenrohres 5 dargestellt. Der Temperaturverlauf längs der z-Achse läßt sich (abgesehen von einer Mittelung der beiden Extreme) damit aber praktisch nicht beeinflussen. Lediglich der Temperaturverlauf kurz vor dem oberen Einspannpunkt des Probenröhrchens 6 läßt sich anheben. Ein linearer Temperaturgradient kann durch wärmeleitende Maßnahmen am Raumtemperaturrohr 4 alleine nicht beseitigt werden.

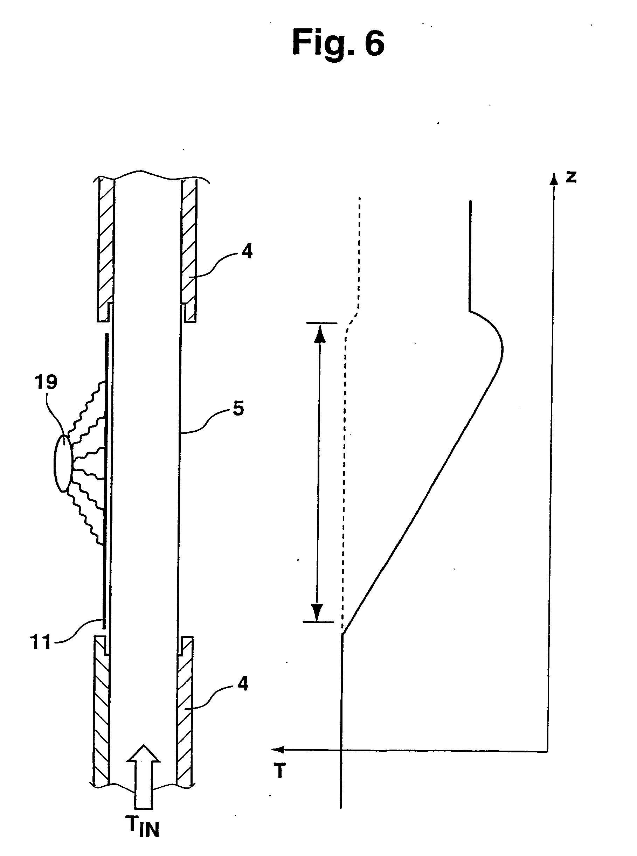

In Fig. 6 ist im schematischen Vertikalquerschnitt ein erfindungsgemäßer NMR-Probenkopf mit einer Temperiereinrichtung 11 im axialen Bereich des Innenrohres 5 eines Raumtemperaturrohres 4 sowie der zugehörige Temperaturverlauf längs der z-Achse dargestellt. Die Temperiereinrichtung 11 kann beispielsweise durch eine elektrische Heizung und/oder durch eine Strahlungsaufheizung einer entsprechenden Fläche am Raumtemperaturrohr 4 im Bereich des Innenrohres 5 mit Hilfe einer Heizeinrichtung 19 realisiert werden. Der rechts im Bild dargestellte Temperaturverlauf längs der z-Achse zeigt in der durchgezogenen Linie die Situation ohne Temperiereinrichtung und gestrichelt die Situation mit einer geregelten Temperiereinrichtung, wo eine nahezu konstante Temperatur längs der gesamten z-Achse beobachtet werden kann.

Die in Fig. 7a schematisch dargestellte Ausführungsform des erfindungsgemä-ßen NMR-Probenkopfes weist ein HF-Empfangsspulensystem 1 auf, welches symmetrisch zu einer z-Achse um ein axial verlaufendes Raumtemperaturrohr 4 angeordnet ist, welches zur Aufnahme eines Probenröhrchens 6 dient, das eine Probensubstanz 7 enthält, die mit Hilfe von NMR-Messungen untersucht werden soll.

Das HF-Empfangsspulensystem 1 ist auf Wärmeleitungselementen 2 aufmontiert, die zur Kühlung des HF-Empfangsspulensystems 1 auf kryogene Temperaturen, in der Regel T₁ ≈ 25 K dienen.

Das Raumtemperaturrohr 4 ist in seinem oberen und unteren Abschnitt mit einem Gehäuse 3 des NMR-Probenkopfes verbunden, während es in seinem mittleren Abschnitt ein für HF-Felder durchlässiges Innenrohr 5 (meist aus Glas) aufweist. Das axial in das Raumtemperaturrohr 4 ragende Probenröhrchen 6 wird mittels eines Gasstromes 8, der ungefähr auf Zimmertemperatur T₂ ≈ 300 K temperiert ist, während der Messungen auf der gewünschten Temperatur gehalten.

Wie aus den Figuren 7a und 7b deutlich wird, sind zwischen dem Empfangsspulensystem 1 und dem Raumtemperaturrohr 4 mehrere Strahlungsschilde 9 angeordnet, die das Raumtemperaturrohr 4 in radialer Richtung umgeben und längs der z-Achse ausgedehnt sind. Die Strahlungsschilde 9 sind aus in z-Richtung ausgerichteten Materialien aufgebaut, welche für HF-Felder nahezu vollständig transparent sind. In radialer Richtung sind die Strahlungsschilde 9 voneinander beabstandet und berühren sich nicht oder zumindest nur punktuell bzw. linienförmig, wie in Fig.7b gut erkennbar ist. Sie weisen eine radiale Dicke < 0,1 mm, vorzugsweise < 50 µm auf. Als bevorzugtes Material für die Strahlungsschilde 9 wird Glas oder Quarz verwendet.

Um die erfindungsgemäß geforderte Ausrichtung des Materials in z-Richtung zu erreichen, können die Strahlungsschilde 9 aus einer unidirektionalen Folie, aus unidirektionalem Gewebe, insbesondere aus Glasfasermatten oder aus axial verlaufenden Stäben oder Fasern, vorzugsweise Glas- oder Quarzfasern oder Faserbündeln aufgebaut sein.

Die Strahlungsschilde 9 können lose im Raum angeordnet und nur an ihren Enden befestigt oder, wie im gezeigten Ausführungsbeispiel am Raumtemperaturrohr 4 befestigt sein.

Der Übersichtlichkeit halber ist in den Figuren 6, 7a und 7b die erfindungsgemäß eingesetzte Zentriervorrichtung nicht gezeigt. Sie kann nach einer der oben beschriebenen Arten realisiert sein.

## Patentansprüche

1. NMR(= Kernspinresonanz)-Probenkopf mit einem auf kryogene Temperaturen abkühlbaren HF(= Hochfrequenz)-Empfangsspulensystem (1) und einem längs einer z-Achse verlaufenden um die Achse zylindersymmetrischen Raumtemperaturrohr (4), in das ein zylindrisches Probenröhrchen (6) eingeführt ist, welches mittels NMR-Messung zu untersuchende Probensubstanz (7) enthält, wobei das HF-Empfangsspulensystem (1) in einem evakuierten Raum außerhalb des Raumtemperaturrohrs (4) angeordnet ist,
**dadurch gekennzeichnet,**
**daß** zur Reduzierung eines Temperaturgradienten in einer Ebene senkrecht zur z-Achse innerhalb der Probensubstanz (7) im Probenröhrchen (6) eine Zentriervorrichtung um die Achse des Raumtemperaturrohres (4) vorgesehen ist, die eine Zentrierung des Probenröhrchens (6) bezüglich des Raumtemperaturrohres (4) bewirkt, wenn sich das Probenröhrchen in Messposition befindet, wobei die Zentriervorrichtung mehrere zwischen dem Raumtemperaturrohr (4) und dem Probenröhrchen (6) azimuthal beabstandete, symmetrisch um die z-Achse des Raumtemperaturrohres (4) herum angeordnete und an der dem Probenröhrchen zugewandten Seite des Raumtemperarturrohr angebrachte Abstandshalter (10) mit zur z-Achse ausschließlich radialer Zentrierwirkung umfasst, wobei im Falle des Zusammenfallens der Zylinderachse des Probenröhrchens mit der z-Achse zwischen den Abstandshaltern (10) und dem Probenröhrchen (6) jeweils ein freier Abstand b verbleibt und wobei zwischen dem Raumtemperaturrohr (4) und dem Probenröhrchen (6) ein radialer Abstand > b vorhanden ist, und daß die Abstandhalter (10) aus in Richtung der z-Achse ausgedehnten Streifen aus federndem Material bestehen, die an ihrem dem Probenröhrchen (6) in dessen Meßposition abgewandten Ende starr mit dem Raumtemperaturrohr (4) verbunden sind, und die an ihrem dem Probenröhrchen (6) in dessen Meßposition zugewandten Ende eine zum Probenröhrchen (6) hin ausgebauchte Sicke aufweisen, deren freier Schenkel an dem Raumtemperaturrohr (4) anliegt.

2. NMR-Probenkopf nach Anspruch 1, **dadurch gekennzeichnet, daß** zwischen 3 und 8, insbesondere 6 Abstandhalter (10) vorhanden sind.

3. NMR-Probenkopf nach Anspruch 1 oder 2, **dadurch gekennzeichnet, daß** die Abstandhalter (10) im Bereich des Bodens des Probenröhrchens (6) in dessen Meßposition an der dem Probenröhrchen (6) zugewandten Seite des Raumtemperaturrohres (4) angebracht sind.

4. NMR-Probenkopf nach Anspruch 1 oder 2, **dadurch gekennzeichnet, daß** die Abstandhalter (10) über die gesamte axiale Länge des HF-Empfangsspulensystems (1) an der dem Probenröhrchen (6) zugewandten Seite des Raumtemperaturrohres (4) angebracht sind.

5. NMR-Probenkopf nach einem der vorhergehenden Ansprüche, **dadurch gekennzeichnet, daß** die Abstandhalter (10) im Bereich der Einfüllöffnung des Raumtemperaturrohres (4) für das Probenröhrchen (6) an der dem Probenröhrchen (6) zugewandten Seite des Raumtemperaturrohres (4) angebracht sind.

6. NMR-Probenkopf nach einem der vorhergehenden Ansprüche, **dadurch gekennzeichnet, daß** die Abstandhalter (10) aus einem für HF-Strahlung transparenten Material aufgebaut sind.

7. NMR-Probenkopf nach einem der vorhergehenden Ansprüche, **dadurch gekennzeichnet, daß** die Abstandhalter (10) aus magnetisch kompensiertem Material aufgebaut sind.

8. NMR-Probenkopf nach Anspruch 7, **dadurch gekennzeichnet, daß** die Abstandhalter (10) aus Blechstreifen einer Dicke von etwa 100µm und einer Breite quer zur z-Achse von etwa 0,5mm bis 2mm, vorzugsweise etwa 1 mm aufgebaut sind.

9. NMR-Probenkopf nach einem der vorhergehenden Ansprüche, **dadurch gekennzeichnet, daß** zwischen dem HF-Empfangsspulensystem (1) und dem Raumtemperaturrohr (4) mindestens ein, vorzugsweise mehrere das Raumtemperaturrohr (4) in radialer Richtung umgebende, in z-Richtung ausgedehnte Strahlungsschilde (9) angeordnet sind, welche aus einem oder mehreren in z-Richtung ausgerichteten Materialien aufgebaut sind, die für HF-Felder nahezu vollständig transparent sind, zumindest aber eine Absorption < 5%, vorzugsweise < 1% für HF-Felder aufweisen.

10. NMR-Probenkopf nach einem der vorhergehenden Ansprüche, **dadurch gekennzeichnet, daß** zwischen dem HF-Empfangsspulensystem (1) und dem Probenröhrchen (6) eine das Probenröhrchen (6) in radialer Richtung umgebende, in z-Richtung ausgedehnte Temperiereinrichtung (11) angeordnet ist, welche vorzugsweise aus Material hoher thermischer Leitfähigkeit aufgebaut ist und für HF-Felder nahezu vollständig transparent ist, zumindest aber eine Absorption < 5%, vorzugsweise < 1% für HF-Felder aufweist.

11. NMR-Probenkopf nach Anspruch 10, **dadurch gekennzeichnet, daß** die Temperiereinrichtung (11) eine oder mehrere Heizschlaufen aus dünnem, insbesondere schichtförmigem, elektrisch gut leitfähigem Material umfaßt, die jeweils einen Hin- und einen Rückleiter aufweisen, wobei die Hin- und Rückleiter der Heizschlaufen jeweils einenends elektrisch miteinander verbunden sind und anderenends mit Heizstrom aus einer Stromquelle beschickt werden können.

## Claims

1. NMR (=nuclear magnetic resonance) probe head comprising an RF (=radio frequency) receiver coil system (1), which can be cooled down to cryogenic temperatures, and a room temperature pipe (4) extending cylinder-symmetrically along a z axis, for receiving a cylindrical sample tube (6) that contains a sample substance (7) to be examined by NMR measurements, wherein the RF receiver coil system (1) is disposed in an evacuated room outside of the room temperature pipe (4), **characterized**
**in that** a centering device is provided about the axis of the room temperature pipe (4) for reducing a temperature gradient in a plane perpendicular to the z axis within the sample substance (7) in the sample tube (6), which centers the sample tube (6) relative to the room temperature pipe (4), when the sample tube is in the measuring position, wherein the centering device comprises several spacers (10), which are disposed symmetrically about the z axis of the room temperature pipe (4) at an azimuthal separation between the room temperature pipe (4) and the sample tube (6), are mounted to the side of the room temperature pipe facing the sample tube, and exhibit a centering action that acts exclusively in a radial direction relative to the z axis, wherein, when the cylinder axis of the sample tube and the z axis coincide, a free space b remains in each case between the spacers (10) and the sample tube (6), and wherein there is a radial separation >b between the room temperature pipe (4) and the sample tube (6), and the spacers (10) consist of strips of resilient material extended in the direction of the z axis, which are rigidly connected at their end, facing away from the sample tube (6) in its measuring position, to the room temperature pipe (4), and have a bead at their end, facing the sample tube (6) in its measuring position, that bulges towards the sample tube (6), whose free leg abuts the room temperature pipe (4).

2. NMR probe head according to claim 1, **characterized in that** between 3 and 8, in particular 6 spacers (10) are provided.

3. NMR probe head according to claim 1 or 2, **characterized in that** the spacers (10) are disposed on the side of the room temperature pipe (4) facing the sample tube (6) in the region of the bottom of the sample tube (6) in its measuring position.

4. NMR probe head according to claim 1 or 2, **characterized in that** the spacers (10) are disposed on the side of the room temperature pipe (4) facing the sample tube (6) over the entire axial length of the RF receiver coil system (1).

5. NMR probe head according to any one of the preceding claims, **characterized in that** the spacers (10) are disposed on the side of the room temperature pipe (4) facing the sample tube (6) in the region of the sample tube (6) feed opening of the room temperature pipe (4).

6. NMR probe head according to any one of the preceding claims, **characterized in that** the spacers (10) are formed of a material which is transparent to RF radiation.

7. NMR probe head according to any one of the preceding claims, **characterized in that** the spacers (10) are made from magnetically compensated material.

8. NMR probe head according to claim 7, **characterized in that** the spacers (10) are made from sheet metal strips having a thickness of approximately 100µm and a width transverse to the z axis of approximately 0.5mm to 2mm, preferably approximately 1mm.

9. NMR probe head according to any one of the preceding claims, **characterized in that** at least one, preferably several radiation shields (9) are disposed between the RF receiver coil system (1) and the room temperature pipe (4), which extend in the z direction and surround the room temperature pipe (4) in a radial direction, and which are made from one or more materials oriented in the z direction, which are almost completely transparent to RF fields, or at least exhibit an absorption for RF fields of <5%, preferably <1%.

10. NMR probe head according to any one of the preceding claims, **characterized in that** a tempering means (11) is disposed between the RF receiver coil system (1) and the sample tube (6), which radially surrounds the sample tube (6), extends in the z direction, is preferably made from a material having a high thermal conductivity, and is almost completely transparent to RF fields or at least has an absorption for RF fields of <5%, preferably < 1%.

11. NMR probe head according to claim 10, **characterized in that** the tempering means (11) comprises one or more heating coils of thin, in particular layered, material having a good electrical conductivity, each comprising an outgoing and return conductor, wherein the outgoing and return conductors of the heating coils are electrically connected to one another at one end and can be supplied with heating current from a current source at the other end.

## Revendications

1. Tête de mesure RMN (= résonance magnétique nucléaire) comprenant un système de bobines de réception HF (= haute fréquence) (1) refroidissable à des température cryogéniques et un tube à température ambiante (4) s'étendant suivant un axe z et à symétrie cylindrique autour de l'axe, dans lequel un tube porte-échantillon cylindrique (6) est introduit, lequel contient une substance échantillon (7) à examiner au moyen de la mesure RMN, le système de bobines de réception HF (1) étant disposé dans une chambre mise au vide à l'extérieur du tube à température ambiante (4),
**caractérisée en ce**
**que** pour réduire un gradient de température dans un plan perpendiculaire à l'axe z à l'intérieur de la substance échantillon (7) dans le tube porte-échantillon (6), il est prévu autour de l'axe du tube à température ambiante (4) un dispositif de centrage qui a pour effet de centrer le tube porte-échantillon (6) par rapport au tube à température ambiante (4) quand le tube porte-échantillon se trouve en position de mesure, le dispositif de centrage comprenant plusieurs écarteurs (10) distants en direction azimutale entre le tube à température ambiante (4) et le tube porte-échantillon (6), disposés symétriquement autour de l'axe z du tube à température ambiante (4) et montés du côté du tube à température ambiante tourné vers le tube porte-échantillon, ayant un effet de centrage exclusivement radial, une distance libre b subsistant entre chacun des écarteurs (10) et le tube porte-échantillon (6) en cas de coïncidence de l'axe cylindrique du tube porte-échantillon avec l'axe z et une distance radiale > b étant présente entre le tube à température ambiante (4) et le tube porte-échantillon (6), et que les écarteurs (10) sont constitués de lamelles en matériau élastique étendues en direction de l'axe z qui sont reliées rigidement au tube à température ambiante (4) à leur extrémité éloignée du tube porte-échantillon (6) dans sa position de mesure et qui, à leur extrémité tournée vers le tube porte-échantillon (6) dans sa position de mesure, présentent une nervure bombée en
direction du tube porte-échantillon (6), dont la branche libre s'applique contre le tube à température ambiante (4).

2. Tête de mesure RMN selon la revendication 1, **caractérisée en ce qu'**entre 3 et 8, en particulier 6 écarteurs (10) sont présents.

3. Tête de mesure RMN selon la revendication 1 ou 2, **caractérisée en ce que** les écarteurs (10) sont montés au niveau du fond du tube porte-échantillon (6) dans sa position de mesure du côté du tube à température ambiante (4) tourné vers le tube porte-échantillon (6).

4. Tête de mesure RMN selon la revendication 1 ou 2, **caractérisée en ce que** les écarteurs (10) sont montés sur toute la longueur axiale du système de bobines de réception HF (1) du côté du tube à température ambiante (4) tourné vers le tube porte-échantillon (6).

5. Tête de mesure RMN selon l'une des revendications précédentes, **caractérisée en ce que** les écarteurs (10) sont montés au niveau de l'ouverture de remplissage du tube à température ambiante (4) pour le tube porte-échantillon (6) du côté du tube à température ambiante (4) tourné vers le tube porte-échantillon (6).

6. Tête de mesure RMN selon l'une des revendications précédentes, **caractérisée en ce que** les écarteurs (10) sont constitués d'un matériau transparent au rayonnement HF.

7. Tête de mesure RMN selon l'une des revendications précédentes, **caractérisée en ce que** les écarteurs (10) sont constitués d'un matériau compensé magnétiquement.

8. Tête de mesure RMN selon la revendication 7, **caractérisée en ce que** les écarteurs (10) sont constitués de lamelles en tôle d'une épaisseur d'environ 100 µm et d'une largeur d'environ 0,5 mm à 2 mm, de préférence environ 1 mm, transversalement à l'axe z.

9. Tête de mesure RMN selon l'une des revendications précédentes, **caractérisée en ce qu'**entre le système de bobines de réception HF (1) et le tube à température ambiante (4) sont disposés au moins un, de préférence plusieurs écrans anti-rayonnement (9) entourant le tube à température ambiante (4) en direction radiale, étendus en direction z, lesquels sont constitués d'un ou plusieurs matériaux alignés en direction z qui sont presque complètement transparents aux champs HF mais présentent au moins une absorption < 5 %, de préférence < 1 %, pour les champs HF.

10. Tête de mesure RMN selon l'une des revendications précédentes, **caractérisée en ce qu'**entre le système de bobines de réception HF (1) et le tube porte-échantillon (6) est disposé un dispositif de régulation de température (11) entourant le tube porte-échantillon (6) en direction radiale, étendu en direction z, lequel est de préférence constitué d'un matériau à haute conductibilité thermique et est presque complètement transparent aux champs HF mais présente au moins une absorption < 5 %, de préférence < 1 %, pour les champs HF.

11. Tête de mesure RMN selon la revendication 10, **caractérisée en ce que** le dispositif de régulation de température (11) comprend une ou plusieurs boucles chauffantes en matériau mince, en particulier en forme de couche, bon conducteur de l'électricité, qui présentent un conducteur aller et un conducteur retour, les conducteurs aller et retour des boucles chauffantes étant chaque fois reliés ensemble électriquement à une extrémité et pouvant être alimentés en courant de chauffage à partir d'une source de courant à l'autre extrémité.
